# EUROPÄISCHE PATENTSCHRIFT

(11) **EP 0 912 995 B1**
(45) Veröffentlichungstag und Bekanntmachung des Hinweises auf die Patenterteilung: **29.05.2002**
(21) Anmeldenummer: 97933624.5
(22) Anmeldetag: 10.07.1997
(51) Int. Cl.: H01L 21/285, H01L 21/265

(54) **HALBLEITERBAUELEMENT MIT NIEDRIGEM KONTAKTWIDERSTAND ZU HOCHDOTIERTEN GEBIETEN**
SEMICONDUCTOR COMPONENT WITH LOW CONTACT RESISTANCE TO HIGHLY DOPED REGIONS
COMPOSANT SEMI-CONDUCTEUR AVEC UNE FAIBLE RESISTANCE DE CONTACT VIS-A-VIS DES REGIONS FORTEMENT DOPEES

(30) Priorität: 15.07.1996 DE 19628459
(43) Veröffentlichungstag der Anmeldung: 06.05.1999
(73) Patentinhaber: Infineon Technologies AG, 81669 München (DE)
(72) Erfinder: PENKA, Volker, D-82008 Unterhaching (DE); MAHNKOPF, Reinhard, D-81479 München (DE); WURZER, Helmut, D-80538 München (DE)
(74) Vertreter: Epping Hermann & Fischer
(86) Internationale Anmeldenummer: DE9701461
(87) Internationale Veröffentlichungsnummer: WO9802914

(56) Entgegenhaltungen:
- US-A- 5 225 357
- US-A- 5 296 386
- US-A- 5 498 768
- CHU C H ET AL: "FORMATION OF SURFACE INVERSION LAYER IN F+-IMPLANTED N-TYPE SILICON" JOURNAL OF CRYSTAL GROWTH, Bd. 103, Nr. 1 / 04, 2.Juni 1990, Seiten 188-196, XP000148184

## Beschreibung

Die Erfindung betrifft ein Verfahren zum Herstellen eines Halbleiterbauelementes mit niedrigem Kontaktwiderstand zu n⁺- oder p⁺-leitenden, hochdotierten Gebieten in einem Halbleiterkörper bei dem in einem Kontaktloch zwischen dem hochdotierten Gebiet und einem mit einer äußeren Zuleitung verbundenen Kontaktmetall mindestens eine Titan enthaltende Schicht vorgesehen ist.

Ein derartiges Verfahren ist aus US-A-5,225,357 bekannt. Hierbei sind n⁺- oder p⁺-leitende, hochdotierte Zonen vorhanden, die in einem Kontaktloch über mindestens eine Titan enthaltende Schicht und einem darauf aufgebrachten Kontaktmetall mit einer äußeren Zuleitung verbunden sind. In die hochdotierten Zonen ist im Bereich des Kontaktloches Halogen eingebracht, um den Kontaktwiderstand zu der hochdotierten Zone zu verringern.

Ferner wird in C.H. Chu et al.: "Formation of surface in version layer in F⁺-implanted n-type silicon", Journal of Crystal Growth, Bd. 103, Nr. 1/4 (Juni 1990), Amsterdam, NL, Seite 188 bis 196, die Implantation von Fluor-Ionen in n-leitendem Silizium beschrieben.

In Kontaktlöchern dienen eine Titanschicht und/oder eine Titannitridschicht als Barriereschicht bzw. Barriereschichten, um eine Diffusion aus dem Halbleiterkörper in eine bevorzugt aus Wolfram bestehende Kontaktschicht zu vermeiden Derartige Kontakte mit einer Schichtenfolge Titan/Titannitrid/Wolfram sind beispielsweise auf Source- und Drain-Zonen von CMOS-Transistoren vorgesehen.

Insbesondere in Kontaktlöchern mit einem sogenannten hohen Aspektverhältnis, also einem hohen Wert des Verhältnisses zwischen Höhe und Breite des Kontaktloches, ist der Kontaktwiderstand in unerwünschter Weise groß. Gleiches gilt auch für silizierte Diffusionsgebiete, also Gebiete, die durch Reaktion von Silizium mit Titan zu Titansilizid gebildet sind.

Zur Verminderung des Kontaktwiderstandes könnte an eine Erhöhung der Schichctdicke der Titanschicht gedacht werden. Dies ist jedoch unerwünscht, da allein schon aus Gründen der Materialeinsparung und der Mikrominiaturisierung die notwendige Schichtdicke der Titanschicht reduziert werden sollte.

Schließlich führen auch dünne Oxidschichten, die sich bei Temperaturprozessen zwangsläufig im Kontaktloch bilden, zu störenden Wirkungen und insbesondere zu einer Erhöhung des Kontaktwiderstandes.

Neben der bereits erwähnten Erhöhung der Schichtdicke der Titanschicht wurde eine kollimiertes Sputtern von Titan zur Bildung der Titanschicht erwogen, um für eine Verminderung des Kontaktwiderstandes zu sorgen. Ein anderer Lösungsansatz zur Herabsetzung des Kontaktwiderstandes besteht in der Anwendung eines zusätzlichen Sputter- und Temperschrittes zur Silizierung des Kontaktlochbodens. Diese beiden zuletzt genannten Lösungsansätze zur Verminderung des Kontaktwiderstandes, nämlich das kollimierte Sputtern von Titan und die Silizierung, sind jedoch relativ aufwendig und haben noch nicht die gewünschten Ergebnisse eines auf einfache Weise ausreichend verminderten Kontaktwiderstandes erbracht.

Es ist daher Aufgabe der vorliegenden Erfindung, ein Verfahren zur Herstellung eines Halbleiterbauelementes anzugeben, bei dem auf einfache Weise der Kontaktwiderstand zu noch dotierten oder silizierten Diffusionsgebieten bei verminderter Schichtdicke der Titanschicht und ohne störende Wirkung von dünnen Oxidschichten herabgesetzt ist.

Diese Aufgabe wird mit den im Anspruch 1 beschriebenen Merkmalen gelöst. Bevorzugte Weiterbildungen sind in den Unteransprüchen beschrieben.

Bei dem erfindungsgemäßen Halbleiterbauelement ist also Fluor in das hochdotierte Gebiet oder silizierte Gebiet durch Ionenimplantation eingebracht. Das Fluor führt dann zu einer erhöhten Wirksamkeit des später in das Kontaktloch hineingesputterten Titans. Im Kontaktloch eventuell vorliegende Oxidschichten, die bei Temperaturprozessen gebildet sind, können durch weniger Titan aufgebrochen werden, und die Bildung von Titansilizid im Kontaktloch wird begünstigt. Insgesamt wird so der Kontaktwiderstand vermindert.

Das Fluor ist mit einer Dosis von etwa 10¹² bis 10¹⁶ Ionen/cm² implantiert. Eine größere Konzentration an Fluor erbringt. keine wesentliche Verbesserung des Kontaktwiderstandes mehr, während eine geringere Konzentration die Wirksamkeit des gesputterten Titans nicht ausreichend erhöht.

In bevorzugter Weise besteht die Schichtenfolge in dem Kontaktloch aus einem Titanfilm, einem darauf aufgebrachten Titannitridfilm und einer Wolframschicht.

Die Fluorionen werden durch das Kontaktloch bei einer Beschleunigungsspannung von etwa 5 bis 50 keV in den Halbleiterkörper implantiert, und es werden so dann in an sich üblicher Weise eine Titanschicht und eine Wolframschicht in dem Kontaktloch auf den Halbleiterkörper aufgetragen.

Durch das Implantieren von Fluorionen in dem hochdotierten oder silizierten Gebiet wird also eine erhöhte Wirksamkeit des in das Kontaktloch des gesputterten Titans erreicht, so daß eventuell vorhandene Oxidschichten mittels weniger Titan aufgebrochen werden und die Bildung von Titansilizid im Kontakcloch erleichtert ist, wodurch eine merkliche Reduzierung des Kontaktwiderstandes erreicht wird.

Nachfolgend wird die Erfindung anhand der Zeichnungen näher erläutert. Es zeigen
- Fig. 1: einen Schnitt durch ein Kontaktloch bei einem Halbleiterbauelement, und
- Fig. 2: in einem Diagramm Versuchsergebnisse zu der Erfindung im Vergleich zum Stand der Technik.

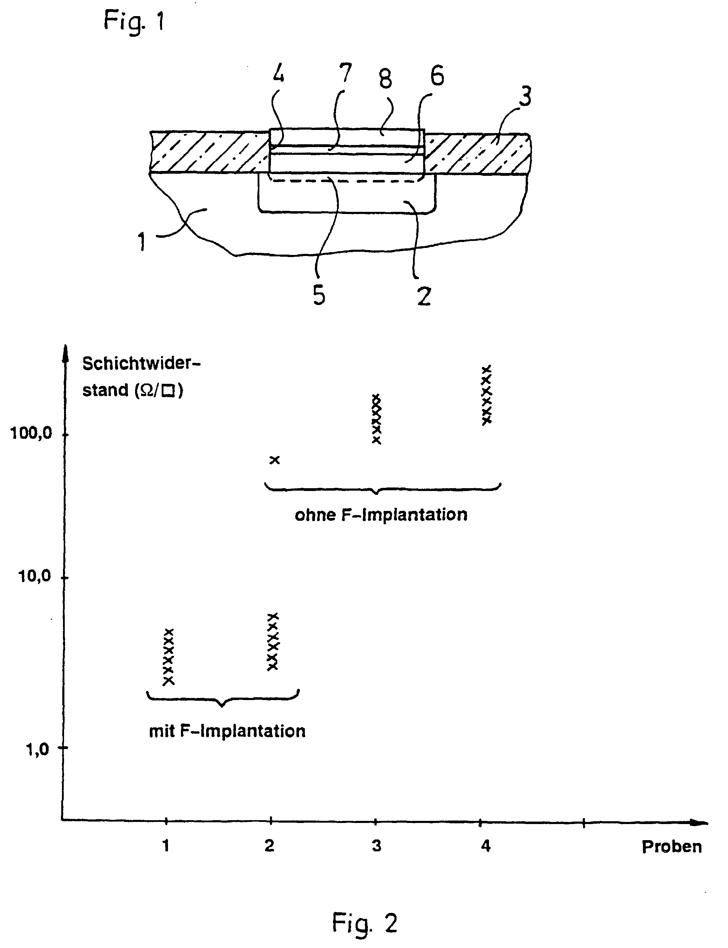

Fig. 1 zeigt einen Schnitt durch beispielsweise den Bereich einer Source- oder Drain-Zone 2 eines CMOS-Transistors in einem Halbleicerkörper 1. Die Zone 2 ist hochdotiert und hat eine Dotierungskonzentration von etwa 10²¹ Atomen/cm³. Es kann sich dabei um eine n⁺-Zone oder eine p⁺-Zone handeln. Der Halbleiterkörper 1 ist mit Ausnahme eines Kontaktloches 4 zu der Zone 2 mit einer Maskierungsschicht 3 bedeckt. Die Zone 2 kann in üblicher Weise, beispielsweise durch Diffusion durch das Kontaktloch 4 in den Halbleiterkörper 1 eingebracht werden.

Wesentlich an der vorliegenden Erfindung ist nun, daß im Bereich des Kontaktloches 4 in der Zone 2 in deren Oberflächenbereich Fluorionen implantiert sind. Die Dosis des Fluors in der Zone 2 beträgt dabei etwa 10¹² bis etwa 10¹⁶. Dieser mit Fluor implantierte Bereich in der Zone 2 ist durch eine Strichlinie 5 angedeutet.

Nach Implantation des Fluors werden im Kontaktloch 4 in üblicher Weise eine Titanschicht 6, eine Titannitridschicht 7 und eine Wolframschicht 8 gebildet. Als äußere Zuleitung wird sodann auf die Wolframschicht 8 eine Aluminiumbahn aufgetragen.

Es hat sich gezeigt, daß Fluor zur Verminderung des Kontaktwiderstandes besonders wirksam ist. Jedoch können gegebenenfalls auch andere Halogene zur Erzielung vergleichbarer Ergebnisse herangezogen werden.

Jedenfalls bewirkt das in die Zone 2 implantierte Fluor, daß im Kontaktloch 4 vorliegende Oxidschichten durch weniger Titan aufgebrochen werden können, so daß die Titanschicht 6 insgesamt dünner aufgesputtert werden kann. Auch wird die Bildung von Titansilizid im Bereich zwischen der Zone 2 und der Titanschicht 6 begünstigt, was wiederum den Kontaktwiderstand vermindert.

Die Vorteile der vorliegenden Erfindung sollen im vorliegenden noch anhand von Fig. 2 erläutert werden, die ein Diagramm mit Versuchsergebnissen zeigt.

Auf großflächige Teststrukturen mit zusammen insgesamt vier Proben wurde eine 40 nm dicke Titanschicht auf eine 65 nm dicke verdichtete TEOS-Schicht (TEOS = Tetraethylorthosilikat) gesputtert und anschließend siliziert. Auf p⁺-dotierten Diffusionsgebieten zeigen die Scheiben der Proben 1 und 2 mit Fluor-Implantation einen stark reduzierten Schichtwiderstand (zwischen etwa 5 und 9 Ω/□) während Scheiben ohne Fluor-Implantation, nämlich die Proben 3 und 4 und ein Meßwert der Probe 2, den üblichen hohen Schichtwiderstand in der Größenordnung von 100 Ω/□ ergeben. Durch die Fluor-Implantation ist der Schichtwiderstand tatsächlich so weit reduziert, daß er dem Schichtwiderstand von reinen silizierten Gebieten ohne Barriereschicht entspricht.

Die Erfindung ermöglicht also ein Halbleiterbauelement, bei dem der Kontaktwiderstand zwischen einer hochdotierten Zone und einer Titan-Barriereschicht stark vermindert ist. Da hierzu lediglich eine Fluor-Implantation notwendig ist, die im übrigen durch das für die Diffusion des hochdotierten Gebiets ohnehin vorhandene Kontaktfenster vorgenommen werden kann, wird die Reduktion des Kontaktwiderstandes auf äußerst einfache Weise erreicht.

Kollimiertes Titan-Sputtern oder Silizierung des Kontaktlochbodens sind nicht erforderlich. Auch kann die unerwünschte Erhöhung der Schichtdicke der Titanschicht vermieden werden, ohne deren Fähigkeit zum Aufbrechen von im Kontaktloch gebildeten Oxidschichten zu vermindern.

## Patentansprüche

1. Verfahren zum Herstellen eines Halbleiterbauelements mit folgenden Verfahrensschritten:
- Erzeugen einer n⁺- oder p⁺-leitenden hochdotierten oder einer silizierten Zone (2) in einem Halbleiterkörper (1) unter einem Kontaktloch (4) in einer Maskierungsschicht (3)
- Implantation von Fluorionen im Bereich des Kontaktloches (2) in den Oberflächenbereich (5) der hochdotierten bzw. silizierten Zone (2), und
- anschließend Auftragen mindestens einer Titan enthaltenden Schicht (6, 7) im Kontaktloch (4) sowie Aufbringen eines Kontaktmetalls (8).

2. Verfahren nach Anspruch 1,
**dadurch gekennzeichnet,**
**daß** das Fluor mit einer Dosis von 10¹² bis 10¹⁶ Ionen/cm² implantiert wird.

3. Verfahren nach Anspruch 1 oder 2,
**dadurch gekennzeichnet,**
**daß** das Fluor mit einer Energie von 5 bis 50 keV implantiert wird.

4. Verfahren nach einem der Ansprüche 1 bis 3,
**dadurch gekennzeichnet,**
**daß** zur Erzeugung der Titan enthaltenden Schicht ein Titanfilm (6) und darauf ein Titannitridfilm (7) aufgetragen wird.

5. Verfahren nach Anspruch 4,
**dadurch gekennzeichnet,**
**daß** der Titanfilm (6) mit einer Schichtdicke von 10 bis 100, insbesondere 40 nm, aufgetragen wird.

## Claims

1. Method for fabricating a semiconductor component, which comprises the following method steps:
producing an n⁺-conducting or p⁺-conducting, heavily doped or siliconized zone (2) in a semiconductor body (1) under a contact hole (4) in a masking layer (3);
implanting fluorine ions in the vicinity of the contact hole (2) into the surface region (5) of the heavily doped or siliconized zone (2), and
subsequently applying at least one titanium-containing layer (6,7) in the contact hole (4) and applying a contact metal (8).

2. Method according to Claim 1, **characterized in that** the fluorine is implanted with a dose of 10¹² to 10¹⁶ ions/cm².

3. Method according to Claim 1 or 2, **characterized in that** the fluorine is implanted with an energy of 5 to 50 keV.

4. Method according to any of Claims 1 to 3, **characterized in that** the titanium-containing layer is produced by applying a titanium film (6) and a titanium nitride film (7) on top of the titanium film.

5. Method according to claim 4, **characterized in that** the titanium film (6) is applied with a layer thickness of 10 to 100, in particular 40, nm.

## Revendications

1. Procédé de fabrication d'un composant à semiconducteur comprenant les stades suivant de procédé :
- production d'une zone (2) à fort dopage de conductivité n⁺ ou de conductivité p⁺, ou d'une zone (2) siliciée dans un corps (1) à semiconducteur sous un trou (4) de contact dans une couche (3) de masquage,
- implantation d'ions fluor dans la région du trou (2) de contact dans la région (5) de surface de la zone (2) très dopée ou siliciée et,
- dépôt ensuite d'au moins une couche (6, 7) contenant du titane dans le trou (4) de contact, ainsi que dépôt d'un métal (8) de contact.

2. Procédé suivant la revendication 1, **caractérisé en ce que** le fluor est implanté en une dose de 10¹² à 10¹⁶ ions/cm².

3. Procédé suivant la revendication 1 ou 2, **caractérisé en ce que** le fluor est implanté à une énergie de 5 à 50 KeV.

4. Procédé suivant l'une des revendications 1 à 3, **caractérisé en ce que** pour la production de la couche contenant du titane, on dépose une pellicule (6) de titane et dessus une pellicule (7) de nitrure de titane.

5. Procédé suivant la revendication 4, **caractérisé en ce que** l'on dépose la pellicule (6) de titane en une épaisseur de couche de 10 à 100 et notamment de 40 nm.
